# EUROPÄISCHE PATENTSCHRIFT

(11) **EP 0 604 790 B1**
(45) Veröffentlichungstag und Bekanntmachung des Hinweises auf die Patenterteilung: **11.09.1996**
(21) Anmeldenummer: 93119654.7
(22) Anmeldetag: 07.12.1993
(51) Int. Cl.: H01L 31/024, H01L 31/02, G01J 5/06, F25D 19/00

(54) **Sensoranordnung mit gekühltem Sensor**
Sensor device with a cooled sensor
Dispositif détecteur avec capteur refroidi

(30) Priorität: 30.12.1992 DE 4244480
(43) Veröffentlichungstag der Anmeldung: 06.07.1994
(73) Patentinhaber: Bodenseewerk Gerätetechnik GmbH, 88662 Überlingen (DE)
(72) Erfinder: Gross, Michael, Dr., D-88662 Überlingen (DE); Uwira, Bernd, Dr., D-78464 Konstanz (DE)
(74) Vertreter: Weisse, Jürgen, Dipl.-Phys. Patentanwalt

(56) Entgegenhaltungen:
- EP-A- 0 518 515
- DE-A- 3 336 490
- DE-A- 3 344 713
- US-A- 4 918 312
- PATENT ABSTRACTS OF JAPAN vol. 12, no. 290 (P-742) (3137) 9. September 1986 & JP-A-63 067 530 (MITSUBISHI ELECTRIC CORPORATION) 26. März 1988

## Beschreibung

Die Erfindung betrifft eine Sensoranordnung mit gekühltem Sensor, bei welcher
(a) der Sensor im Vakuumraum eines Dewar-Gefäßes angeordnet ist,
(b) das Dewar-Gefäß einen inneren einen äußeren Gehäuseteil aufweist,
(c) die Gehäuseteile topfförmig ausgebildet sind, wobei der äußere Gehäuseteil um den inneren Gehäuseteil greift, und den Vakuumraum des Dewar-Gefäßes begrenzen,
(d) der innere Gehäuseteil radial abgestützt ist,
(e) der innere Gehäuseteil auf seiner vakuumseitigen Außenseite den Sensor trägt und
(f) der innere Gehäuseteil in seinem dem Vakuum abgewandten Innenraum einen Kühler umschließt.

Solche Sensoren sind insbesondere infrarotempfindliche Sensoren für Sucher, die ein infrarot strahlendes Ziel verfolgen. Solche Sucher werden in Suchköpfen von zielsuchenden Flugkörpern benutzt.

Zur Erhöhung der Empfindlichkeit des Sensors und zur Verminderung des Rauschens werden solche Sensoren durch einen Kühler gekühlt. Zu diesem Zweck ist ein Dewar-Gefäß vorgesehen. Dieses Dewar-Gefäß enthält ein topfförmiges, inneres Gehäuseteil und ein ebenso topfförmiges äußeres Gehäuseteil. Das äußere Gehäuseteil umgreift das innere Gehäuseteil. Die Gehäuseteile sind miteinander verbunden und begrenzen einen Vakuumraum. Der Vakuumraum ist evakuiert. Dadurch wird der Wärmeübergang zwischen den Gehäuseteilen vermindert. Ein Kühler sitzt in dem dem Vakuum abgewandten Innenraum des topfförmigen, inneren Gehäuseteils. Der Kühler ist üblicherweise ein Joule-Thomson-Kühler. Ein zu kühlender Sensor sitzt auf dem "Boden" des topfförmigen inneren Gehäuseteils in der Vakuumkammer. Der "Boden" des äußeren Gehäuseteils enthält ein für Infrarot durchlässiges Fenster. Der Sensor kann ein einzelnes infrarotempfindliches Detektor-Element sein. Der Detektor kann aber auch von einer ein- oder zweidimensionalen Anordnung solcher Detektorelemente gebildet sein.

Solche Sensoren müssen häufig auf sehr engem Raum untergebracht werden. Die spezifizierten Leistungsdaten der Sensoren dürfen nicht durch elektromagnetische Störeinflüsse beeinträchtigt werden. Sie müssen elektromagnetische Verträglichkeit zeigen. Weiterhin sollte der Kühlaufwand gering gehalten werden. Das gilt sowohl für die Baugröße und das Gewicht als auch für den Leistungs- und Kühlmittelverbrauch der Kühleinrichtung. Die Abkühlzeit sollte kurz sein, um den Sensor unmittelbar nach der Aktivierung einsetzen zu können.

Der Sensor muß hohe Beschleunigungen jedenfalls über kurze Zeit ohne Schaden überstehen können. Bei Vibrationen können durch Eigenschwingungen der Sensorhalterung unerwünschte Signal-Modulationen auftreten. Daher sollen die Eigenfrequenzen möglichst hoch sein. Maßnahmen zur Erhöhung der Eigenfrequenzen dürfen aber den Wärmehaushalt des Sensors nicht nachteilig beeinflussen.

Es wird weiter in bestimmten Fällen die Forderung gestellt, daß die Sensoranordnung eine lange Lebensdauer von bis zu zwanzig Jahren haben soll.

Es ist bekannt, den inneren Gehäuseteil aus Glas herzustellen. Die elektrischen Leiterbahnen zur Verbindung mit dem Sensor sind längs der Mantelfläche des inneren Gehäuseteils geführt. Es ist auch bekannt (DE-PS 22 47 845) die Leiterbahnen in die Wand des inneren, rohrförmigen Teiles einzubetten. Solche Leiterbahnen sind metallisch und daher gut wärmeleitend. Zur Vermeidung von Wärmeverlusten muß das innere Gehäuseteil mit den Leiterbahnen entsprechend lang ausgeführt werden. Die Leiterbahnen müssen möglichst dünn sein. Sehr dünne Leiterbahnen beeinträchtigen die Signalübertragung. Lange Gehäuseteile widersprechen der Forderung nach Unterbringung der Sensoren auf engem Raum.

Bei manchen Sensoren, insbesondere Bildsensoren, werden viele Leiterbahnen benötigt. Über diese Leiterbahnen werden zum Teil hochfrequente Signale übertragen. Bei der Unterbringung vieler solcher Leiterbahnen nebeneinander auf der Mantelfläche des inneren Gehäuseteiles ergibt sich das Problem des Übersprechens. Maßnahmen nach dem Stand der Technik zur Abschirmung der Leitungen gegeneinander sind unbefriedigend. Beispielsweise werden Masseleitungen zwischen benachbarte Signalleitungen eingefügt. Dadurch wird aber die Anzahl der realisierbaren Signalleitungen stark verringert. Das ist für komplexe Sensoren wie Bildsensoren nicht tragbar.

Wenn das innere Gehäuseteil zur Erhöhung der Eigenfrequenzen an dem steiferen äußeren Gehäuseteil abgestützt wird (z.B. JP-PS 52-60982), dann wird über die Abstützung ein unerwünscht hoher Wärmefluß von dem warmen äußeren Gehäuseteil auf den kalten inneren Gehäuseteil und den Sensor hervorgerufen.

Probleme ergeben sich beim Stand der Technik auch hinsichtlich der Abschirmung gegen elektromagnetische Störeinflüsse.

Es ist bekannt, ein Dewar-Gefäß mit einem inneren und einem äußeren Gehäuseteil aus Glas aufzubauen und diese mit einem Außenrohr aus Metall zu umgeben (DE-OS 27 30 945). Die Leiterbahnen sind dabei längs der Mantelfläche des inneren Gehäuseteils geführt. Eine solche Anordnung hat ebenfalls die Nachteile der vorstehend geschilderten bekannten Anordnungen hinsichtlich Steifigkeit und Übersprechen. Durch das Außenrohr wird bei gleichem für die Gesamtanordnung zur Verfügung stehenden Raum das Volumen der Vakuumkammer vermindert. Bei einer technisch bestimmten Leckrate wird hierdurch die Lebensdauer etwa auf ein Drittel verkürzt.

Der Erfindung liegt die Aufgabe zugrunde, eine Sensoranordnung der eingangs genannten Art mit gekühltem Sensor so auszubilden, daß sie geringe Abmessungen und gute thermische Eigenschaften besitzt, eine lange Lebensdauer hat und unempfindlich gegen äußere Störeinflüsse ist.

Erfindungsgemäß wird diese Aufgabe dadurch gelöst, daß
(g) im Vakuumraum des Dewar-Gefäßes ein rohrförmiger Stützkörper angeordnet ist, der an einem Sockel auf der dem Sensor abgewandten Ende gehalten ist und den inneren Gehäuseteil umgibt,
(h) der Stützkörper aus mehreren, einander umschließenden rohrförmigen Lagen besteht,
(i) die Zuleitungen zu dem Sensor auf den Mantelflächen der Lagen des Stützkörpers angebracht sind.

Bei der erfindungsgemäßen Sensoranordnung ist im Vakuum ein zusätzlicher Stützkörper angeordnet. Dieser Stützkörper stützt den inneren Gehäuseteil. Die Stützglieder erstrecken sich dadurch nicht zu dem warmen äußeren Gehäuseteil, so daß der Wärmefluß gering ist. Der Stützkörper ist mehrlagig und enthält die Zuleitungen zu dem Sensor. Dabei kann eine ziemlich große Anzahl von Zuleitungen vorgesehen werden, die in den verschiedenen Lagen gegeneinander abgeschirmt werden können, so daß die Gefahr des Übersprechens entfällt. Es können einzelne Lagen als Abschirmung vorgesehen werden.

Bei einer bevorzugten Ausführung bestehen der innere und der äußere Gehäuseteil aus Metall. Der Stützkörper besteht aus Keramik, nämlich aus Mehrlagen-Glaskeramik. Sensornahe Signalverarbeitungs-Elektronik ist innerhalb des Vakuumraumes auf dem Stützkörper montiert. Die Signalverarbeitungs-Elektronik enthält dabei Vorverarbeitungsstufen zur Verminderung der Anzahl der aus dem Vakuumraum herauszuführenden Leitungen.

Das Dewar-Gefäß weist einen flanschförmigen Sockel auf mit einem ersten Sockelteil, das mit dem äußeren Gehäuseteil verbunden ist, einem zweiten Sockelteil, das mit dem inneren Gehäuseteil verbunden ist, und einer ringscheibenförmigen Platine, die abdichtend zwischen erstem und zweitem Sockelteil gehalten ist und den Vakuumraum begrenzt. Die Platine ist mehrlagig ausgeführt und weist zur dichten Herausführung von Leitungen aus dem Vakuumraum gegeneinander versetzte Durchsteiger auf, die durch Leitungen auf den verschiedenen Lagen der Platine miteinander verbunden sind. Die Platine trägt innerhalb und außerhalb des Vakuumraumes Bauteile der Elektronik des Sensors.

Ein Ausführungsbeispiel der Erfindung ist nachstehend unter Bezugnahme auf die zugehörigen Zeichnungen näher erläutert.
- Fig.1: ist eine perspektivische Darstellung, teilweise im Schnitt, einer Sensoranordnung mit gekühltem Sensor.
- Fig.2: zeigt einen Längsschnitt der Sensoranordnung von Fig.1.
- Fig.3: zeigt in vergrößertem Maßstab eine Draufsicht auf das Substrat und den Sensor der Sensoranordnung von Fig.1 und 2.
- Fig.4: ist eine schematisch-perspektivische Darstellung, teilweise im Schnitt, eines Stützkörpers bei der Sensoranordnung von Fig.1.

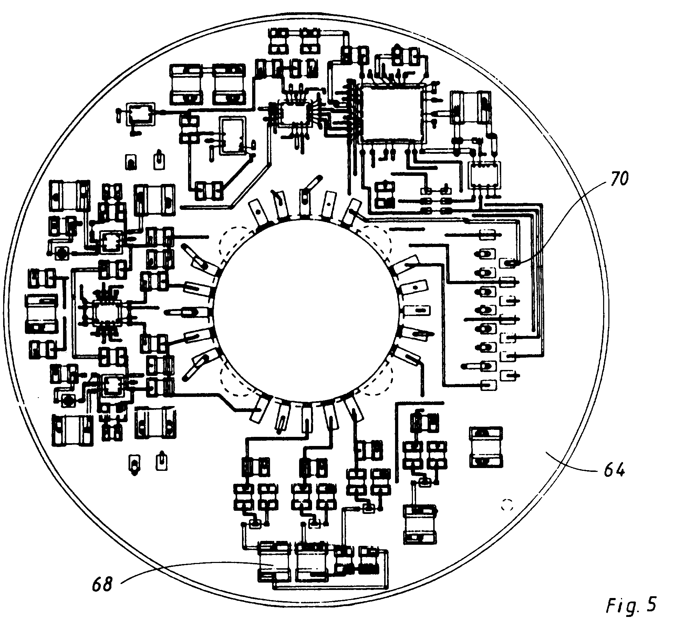

- Fig.5: ist eine Draufsicht einer Platine im Sockel der Sensoranordnung von Fig.1.
- Fig.6: ist eine schematisch-perspektivische Darstellung der Platine von Fig.3.

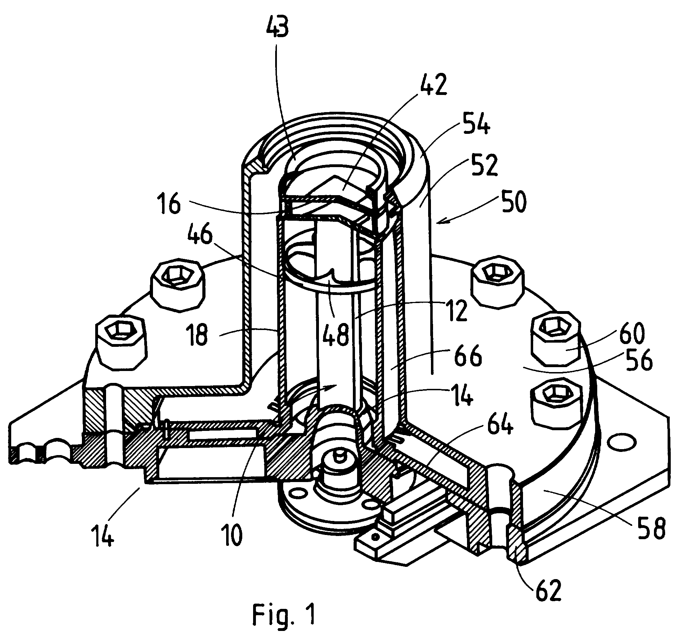

Die Sensoranordnung enthält einen inneren Gehäuseteil 10. Der innere Gehäuseteil weist ein Rohr 12 aus Metall auf. Das Rohr 12 ist an seinem in Fig.1 unteren Ende in einem Sockel 14 gehaltert. An seinem in Fig.1 oberen Ende ist das Rohr durch eine Platte 16 dicht abgeschlossen. Die Platte 16 bildet den "Boden" des topfförmigen, inneren Gehäuseteils. Die Platte 16 ragt jedoch seitlich über das Rohr 12 hinaus. Im Inneren des Rohres 12 ist eine Kühlvorrichtung 17 in Form eines Joule-Thomson-Kühlers angeordnet.

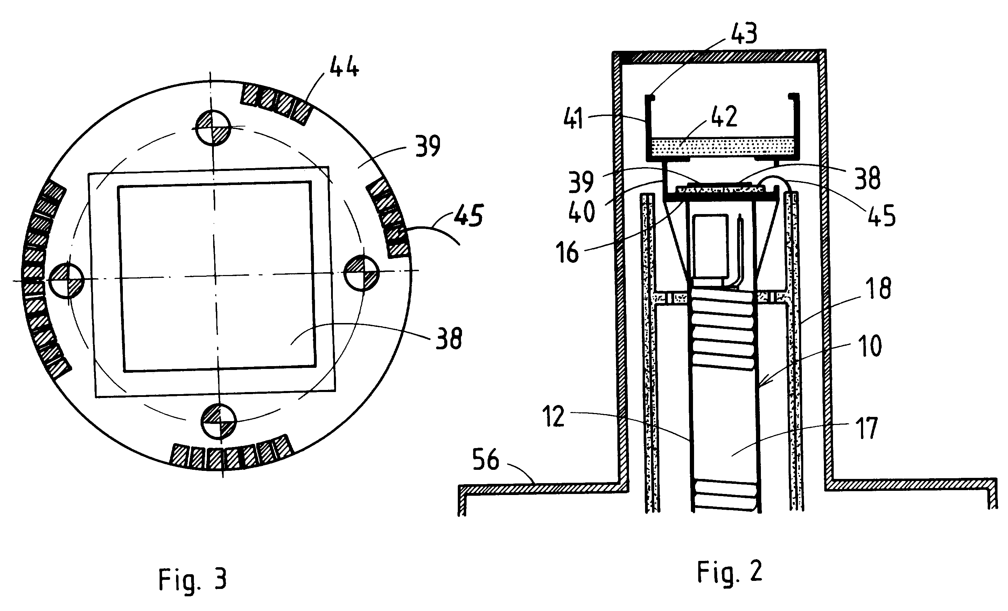

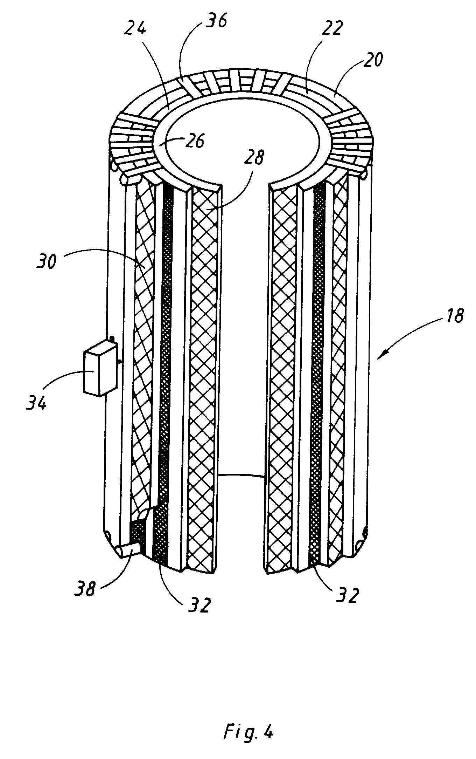

Das Rohr 12 ist koaxial von einem als Hohlkörper geformten Stützkörper 18 aus einer Mehrlagen-Glaskeramik umgeben. Die Mehrlagen-Glaskeramik enthält ein elektrisch leitfähiges Netzwerk. Das ist in Fig.4 dargestellt. Der Stützkörper 18 von Fig.4 besteht aus vier Lagen 20, 22, 24 und 26. Die innerste Lage 26 ist auf ihrer Außenseite mit einer elektrischen Abschirmung 28 versehen. Ebenso ist die zweitäußerste Lage 22 auf ihrer Außenseite mit einer elektrischen Abschirmung 30 versehen. Die dazwischenliegende Lage 24 ist mit längsverlaufenden Leiterbahnen 32 versehen. Diese Leiterbahnen 32 bilden die Signalleitungen. Es können natürlich auch mehr als die in Fig.2 dargestellten vier gegeneinander abgeschirmten Lagen vorgesehen sein. Elektronische Bauteile und Schaltungselemente 34 sind auf der Mantelfläche des Stützkörpers 18 montiert. Diese elektronischen Bauteile bewirken eine Vorverarbeitung der Signale des Sensors und eine Verminderung der aus dem Vakuum herauszuführenden Leitungen.

Die elektronischen Bauteile sind mittels Durchkontaktierung mit dem auf die verschiedenen Lagen aufgebrachten Leitungsnetzwerk verbunden. Die Verbindung zwischen den auf dem inneren Gehäuseteil 10 angeordneten Bauteilen, insbesondere dem Sensor, und den Leiterbahnen auf den verschiedenen Lagen des Stützkörpers 18 erfolgt mit Hilfe von Durchsteigern 36 in der Stirnfläche des Stützkörpers 18. Die von den Durchsteigern 36 gebildeten Kontakte sind zu diesem Zweck durch Anschleifen der Glaskeramik zu einem gewissen Teil freigelegt. Die von den Durchsteigern 36 gebildeten Kontakte sind mit Anschlüssen eines Sensors 38 verbunden.

Der Sensor 38 ist ein Bildsensor mit einer zweidimensionalen Anordnung von infrarotempfindlichen Detektorelementen. Der Sensor kann natürlich auch von einer eindimensionalen Anordnung von Detektorelementen gebildet sein. Der Sensor 38 sitzt auf einem Substrat 39. Das Substrat 39 sitzt auf der Platte 16.

Die Platte 16 trägt über Stützen 40 eine Fassung 41. Die Fassung 41 nimmt ein Kaltfilter 42 auf. Weiterhin bildet die Fassung 41 eine Kaltblende 43. Das Kaltfilter 42 und die Kaltblende 43 sind von der Küklvorrichtung 17 mit gekühlt. Dadurch wird die infrarote Wärmestrahlung vermindert, die von dem Kaltfilter 42 und der Kaltblende 43 selbst ausgesandt wird und auch auf den Sensor 38 fällt. Die Kaltblende 43 schirmt den Sensor 38 gegen Wärmestrahlung ab, die von der warmen Umgebung ausgesandt wird.

Das Substrat 39 trägt an seinem Rand Kontakte 44. Die Kontakte 44 sind über Kontaktdrähte 45 mit den an der Stirnfläche des Stützkörpers 18 durch die Durchsteiger 36 gebildeten Kontakten verbunden. Diese Kontakte stehen wieder mit den verschiedenen Leiterbahnen 32 in Verbindung.

Das Rohr 12 des inneren Gehäuseteils 10 besteht aus dünnem Metall. Das Rohr 12 ist über einen Stützring 46 an dem Stützkörper 18 abgestützt. Der Stützring 46 sitzt in dem Stützkörper 18 und liegt mit drei um 120° gegeneinander winkelversetzten Vorsprüngen 48 an dem Rohr 12 an.

Das Dewar-Gefäß weist einen äußeren Gehäuseteil 50 auf, der ebenfalls aus Metall besteht. Der äußere Gehäuseteil 50 weist einen rohrförmigen Mantelteil 52 auf. Der Mantelteil 52 bildet an seinem in Fig.1 oberen Rand eine Fassung 54 für ein (nicht dargestelltes) infrarotdurchlässiges Fenster. An seinem in Fig.1 unteren Ende geht der Mantelteil 52 in einen sich radial nach außen erstreckenden oberen Sockelteil 56 über. Der obere Sockelteil 56 weist einen verdickten Rand 58 auf. Der verdickte Rand 58 ist durch Schrauben 60 mit einem unteren Sockelteil 62 verbunden. Der untere Sockelteil 62 bildet in der Mitte den Sockel 14, der das Rohr 12 aufnimmt. Zwischen dem oberen Sockelteil 56 und dem unteren Sockelteil 62 ist abdichtend eine ringscheibenförmige Platine 64 aus Mehrlagen-Glaskeramik gehaltert. Eine Vakuumkammer 66 wird von dem äußeren Gehäuseteil 50 (mit dem oberen Sockelteil 56 dem Mantelteil 52, der Fassung 54 und dem Fenster), der Platine 64 und dem inneren Gehäuseteil 10 (mit dem Sockel 14, dem Rohr 12 und der Platte 16) begrenzt. Diese Vakuumkammer 66 ist evakuiert. In der Vakuumkammer 66 sitzt der Stützkörper 18.

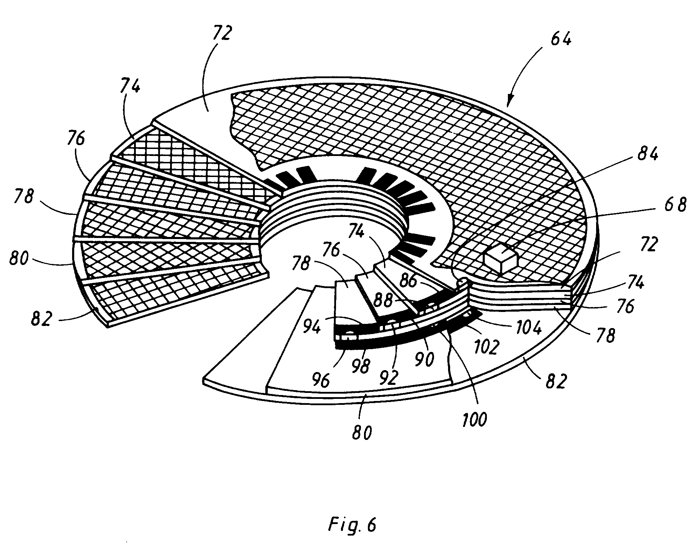

Die Platine 64 trägt Bauteile 68 sensornaher Elektronik, wie in Fig.3 dargestellt ist. Außerdem enthält die aus Mehrlagen-Glaskeramik hergestellte Platine 68 integrierte Durchführungen 70 zum Herausführen von Leitungen aus dem Vakuum in der Vakuumkammer 66. Wie aus Fig.6 ersichtlich ist, besteht die Platine 64 aus mehreren Lagen 72, 74, 76, 78, 80 und 82. Ein auf der obersten Lage 72 angeordnetes Bauteil ist über einen Durchsteiger 84 mit einer Leiterbahn 86 der Lage 74 verbunden. Die Leiterbahn 86 erstreckt sich eine gewisse Strecke in Umfangsrichtung längs der Lage 74. Die Leiterbahn 86 ist über einen Durchsteiger 88 mit einer Leiterbahn 90 der Lage 76 verbunden. Die Leiterbahn 90 erstreckt sich ebenfalls eine gewisse Strecke in Umfangsrichtung längs der Lage 76. Die Leiterbahn 90 ist dann über einen Durchsteiger 92 mit einer Leiterbahn 94 der Lage 78 verbunden. Die Leiterbahn 94 erstreckt sich eine weitere Strecke in Umfangsrichtung längs der Lage 78. Die Leiterbahn 94 ist dann über einen Durchsteiger 96 mit einer Leiterbahn 98 der Lage 80 verbunden. Die Leiterbahn 98 erstreckt sich über eine Strecke in Umfangsrichtung unterhalb der Leiterbahnen 90 und 94 längs der Lage 80. Dann ist die Leiterbahn 98 über einen Durchsteiger 100 mit einer Leiterbahn 102 der Lage 82 verbunden. Auch die Leiterbahn 102 erstreckt sich eine Strecke in Umfangsrichtung unterhalb der Leiterbahn 86 längs der Lage 82. Schließlich ist mittels eines Durchsteigers 104 eine Verbindung zu der außerhalb des Vakuums befindlichen Unterseite der Lage 82 und damit der Platine 64 hergestellt. Auf diese Weise wird eine gasdichte elektrische Durchführung aus der Vakuumkammer heraus erhalten.

Die in der Vakuumkammer 66 auf dem Stützkörper 18 oder der Platine 64 angeordnete, sensornahe Elektronik vermindert durch Signalvorverarbeitung die Anzahl der aus der Vakuumkammer 66 herauszuführenden Leitungen. Auch das vermindert die Leckrate. Die verminderte Leckrate in Verbindung mit dem relativ großen Volumen der Vakuumkammer wirkt sich im Sinne einer Erhöhung der Lebensdauer der Sensoranordnung aus.

Dadurch, daß der äußere Gehäuseteil 50 wie der innere Gehäuseteil 10 aus Metall besteht, wird der Sensor durch äußere elektromagnetische Störungen nicht beeinflußt.

## Patentansprüche

1. Sensoranordnung mit gekühltem Sensor, bei welcher
(a) der Sensor (38) im Vakuumraum (66) eines Dewar-Gefäßes angeordnet ist,
(b) das Dewar-Gefäß einen inneren und einen äußeren Gehäuseteil (10,50) aufweist,
(c) die Gehäuseteile (10,50) topfförmig ausgebildet sind, wobei der äußere Gehäuseteil (50) um den inneren Gehäuseteil (10) greift, und den Vakuumraum (66) des Dewar-Gefäßes begrenzen,
(d) der innere Gehäuseteil (10) radial abgestützt ist,
(e) der innere Gehäuseteil (10) auf seiner vakuumseitigen Außenseite den Sensor (38) trägt und
(f) der innere Gehäuseteil (10) in seinem dem Vakuum abgewandten Innenraum einen Kühler umschließt,
**dadurch gekennzeichnet, daß**
(g) im Vakuumraum (66) des Dewar-Gefäßes ein rohrförmiger Stützkörper (18) angeordnet ist, der an einem Sockel auf der dem Sensor abgewandten Ende gehalten ist und den inneren Gehäuseteil (10) umgibt,
(h) der Stützkörper (18) aus mehreren, einander umschließenden rohrförmigen Lagen (20,22,24,26) besteht,
(i) die Zuleitungen (32) zu dem Sensor (40) auf den Mantelflächen der Lagen (20,22,24,26) des Stützkörpers (18) angebracht sind.

2. Sensoranordnung nach Anspruch 1, **dadurch gekennzeichnet, daß** der innere und der äußere Gehäuseteil (10,50) aus Metall bestehen.

3. Sensoranordnung nach Anspruch 1 oder 2, **dadurch gekennzeichnet, daß** der Stützkörper (18) aus Keramik besteht.

4. Sensoranordnung nach Anspruch 3, **dadurch gekennzeichnet, daß** der Stützkörper (18) aus Mehrlagen-Glaskeramik besteht.

5. Sensoranordnung nach einem der Ansprüche 1 bis 4, **dadurch gekennzeichnet, daß** sensornahe Signalverarbeitungs-Elektronik (34) innerhalb des Vakuumraumes (66) auf dem Stützkörper (18) montiert ist.

6. Sensoranordnung nach Anspruch 5, **dadurch gekennzeichnet, daß** die Signalverarbeitungs-Elektronik Signalvorverarbeitungsstufen Verminderung der Anzahl der aus dem Vakuumraum (66) herauszuführenden Leitungen enthält.

7. Sensoranordnung nach einem der Ansprüche 1 bis 6, **dadurch gekennzeichnet, daß**
(a) das Dewar-Gefäß einen flanschförmigen Sockel aufweist mit einem ersten Sockelteil (56), das mit dem äußeren Gehäuseteil (50) verbunden ist, einem zweiten Sockelteil (62), das mit dem inneren Gehäuseteil (10) verbunden ist, und einer ringscheibenförmigen Platine (64), die abdichtend zwischen erstem und zweitem Sockelteil (56,62) gehalten ist und den Vakuumraum (66) begrenzt,
(b) die Platine (64) mehrlagig ausgeführt ist und zur dichten Herausführung von Leitungen aus dem Vakuumraum (66) gegeneinander versetzte Durchsteiger (84,88,92,96,100,104) aufweist, die durch Leiterbahnen (86,90,94,98,102) auf den verschiedenen Lagen (72,74,76,78,80,82) der Platine (64) miteinander verbunden sind.

8. Sensoranordnung nach Anspruch 7, **dadurch gekennzeichnet, daß** die Platine (64) innerhalb des Vakuumraumes (66) Bauteile (68) der Elektronik des Sensors (38) trägt.

## Claims

1. Sensor assembly with cooled sensor, wherein
(a) the sensor (38) is arranged in the vacuum chamber (66) of a Dewar vessel,
(b) the Dewar vessel has an inner and an outer housing element (10,50),
(c) the housing elements are pot-shaped, the outer housing element (50) extending around the inner housing element (10), the housing elements limiting the vacuum chamber (66) of the Dewar vessel,
(d) the inner housing element (10) is radially supported,
(e) the inner housing element (10) carrying the sensor (38) on its outer surface facing the vaccum, and
(f) the inner housing element (10) encloses a cooler in its inner cavity remote from the vacuum,
**characterized in that**
(g) a tubular support body (18) is arranged in the vacuum chamber (66) of the Dewar vessel and is held in a socket at the end remote from the sensor and surrounds the inner housing element,
(h) the support body (18) consists of a plurality of tubular layers (20,22,24,26) surrounding each other,
(i) the connecting conductors (32) leading to the sensor (40) are provided on the peripheral surfaces of the layers (20,22,24,26) of the support body (18).

2. Sensor assembly as claimed in claim 1, **characterized in that** the inner and outer housing elements (10,50) consist of metal.

3. Sensor assembly as claimed in claim 1 or 2, **characterized in that** the support body (18) consists of ceramics.

4. Sensor assembly as claimed in claim 3, **characterized in that** the support body consists of multi-layer glass ceramics.

5. Sensor assembly as claimed in anyone of the claims 1 to 4, **characterized in that** the near-the-sensor signal processing electronics (34) is mounted on the support body (18) inside the vacuum chamber (66).

6. Sensor assembly as claimed in claim 5, **characterized in that** the signal processing electronics comprises a signal pre-processing stage for reducing the number of conductors to be passed out of the vacuum chamber (66).

7. Sensor assembly as claimed in anyone of the claims 1 to 6, **characterized in that**
(a) the Dewar vessel has a flange-shaped socket with a first socket element (56), which is connected with the outer housing element (50), a second socket element (62) which is connected with the inner housing element (10), and an annular disc-shaped printed circuit board (64) which is held sealingly between first and second socket elements (56,62) and limits the vacuum chamber (66),
(b) the printed circuit board (64) is a multi-layer board and has mutually offset feed-through conductors (84,88,92,100,104) for sealingly passing lines out of the vacuum chamber (66), said feed-through conductors being interconnected by strip conductors (86,90,94,98,102)on the various layers (72,74,76,78,80,82) of the printed circuit board.

8. Sensor assembly as claimed in claim 7, **characterized in that** the printed circuit board (64), inside the vacuum chamber, carries components (68) of the electronics of the sensor (38).

## Revendications

1. Disposition de capteur munie d'un capteur refroidi pour laquelle
(a) le capteur (38) est disposé dans l'espace vide d'air (66) d'un récipient Dewar,
(b) le récipient Dewar présente un élément intérieur de boîtier et un élément extérieur de boîtier (10,50),
(c) les éléments de boîtier (10,50) sont développés en forme de pot, l'élément extérieur de boîtier (50) mordant sur l'élément intérieur de boîtier (10) et délimitant l'espace vide d'air (66) du récipient Dewar,
(d) l'élément intérieur de boîtier (10) est appuyé radialement,
(e) l'élément intérieur de boîtier (10) porte le capteur (38) sur sa face extérieure située du côté du vide d'air et
(f) l'élément intérieur de boîtier (10) renferme un refroidisseur dans son espace intérieur opposé au vide d'air,
**caractérisée par le fait que**
(g) un corps de soutien tubulaire (18), maintenu à un socle sur l'extrémité opposée au capteur et entourant l'élément intérieur de boîtier (10), est disposé dans l'espace vide d'air (66) du récipient Dewar,
(h) le corps de soutien (18) se compose de plusieurs couches tubulaires s'entourant réciproquement (20,22,24,26),
(i) les conducteurs d'amenée (32) menant au capteur (40) sont placés sur les surfaces de manteau des couches (20,22,24,26) du corps de soutien (18).

2. Disposition de capteur selon la revendication 1, **caractérisée par le fait que** l'élément intérieur de boîtier et l'élément extérieur de boîtier (10,50) se composent de métal.

3. Disposition de capteur selon la revendication 1 ou 2, **caractérisée par le fait que** le corps de soutien (18) se compose de céramique.

4. Disposition de capteur selon la revendication 3, **caractérisée par le fait que** le corps de soutien (18) se compose de vitrocéramique à plusieurs couches.

5. Disposition de capteur selon l'une des revendications 1 à 4, **caractérisée par le fait que** l'électronique de traitement de signaux (34) proche du capteur est montée à l'intérieur de l'espace vide d'air (66) sur le corps de soutien (18).

6. Disposition de capteur selon la revendication 5, **caractérisée par le fait que** l'électronique de traitement de signaux comprend des étapes de traitement de signaux destinées à réduire le nombre des conducteurs dépassant de l'espace vide d'air (66).

7. Disposition de capteur selon l'une des revendications 1 à 6, **caractérisée par le fait que**
(a) le récipient Dewar présente un socle en forme de bride muni d'un premier élément de socle (56) relié à l'élément extérieur de boîtier (50), d'un second élément de socle (62) relié à l'élément intérieur de boîtier (10) et d'une platine (64) en forme de disque annulaire qui est maintenue de façon étanchante entre le premier et le second élément de socle (56,62) et qui délimite l'espace vide d'air (66),
(b) la platine (64) est construite en plusieurs couches et présente des réglettes (84,88,92,96,100,104) décalées les unes des autres et reliées les unes aux autres par des pistes conductrices (86,90,94,98,102) sur les différentes couches (72,74,76,78,80,82) de la platine (64) afin de faire dépasser hermétiquement des conducteurs de l'espace vide d'air (66).

8. Disposition de capteur selon la revendication 7, caractérisée par le fait que la platine (64) porte à l'intérieur de l'espace vide d'air (66) des composants (68) de l'électronique du capteur (38).
